# EUROPÄISCHE PATENTSCHRIFT

(11) **EP 2 796 026 B1**
(45) Veröffentlichungstag und Bekanntmachung des Hinweises auf die Patenterteilung: **07.03.2018**
(21) Anmeldenummer: 12803513.6
(22) Anmeldetag: 05.12.2012
(51) Int. Cl.: H05K 9/00, B32B 15/00, B60L 11/18, B62D 25/20, H01F 27/36, H01F 38/14

(54) **MAGNETFELDABSCHIRMUNG FÜR ELEKTROMAGNETISCHE FELDER UND FAHRZEUG MIT INTEGRIERTER MAGNETFELDABSCHIRMUNG**
MAGNETIC FIELD SHIELD FOR ELECTROMAGNETIC FIELDS AND VEHICLE HAVING AN INTEGRATED MAGNETIC FIELD SHIELD
BLINDAGE DE CHAMP MAGNÉTIQUE POUR CHAMPS ÉLECTROMAGNÉTIQUES ET VÉHICULE AVEC BLINDAGE DE CHAMP MAGNÉTIQUE INTÉGRÉ

(30) Priorität: 21.12.2011 DE 102011056807
(43) Veröffentlichungstag der Anmeldung: 29.10.2014
(73) Patentinhaber: ThyssenKrupp Steel Europe AG, 47166 Duisburg (DE); ThyssenKrupp Electrical Steel GmbH, 45881 Gelsenkirchen (DE)
(72) Erfinder: KEUTZ, Andreas, 40477 Düsseldorf (DE); DORNER, Dorothée, 40629 Düsseldorf (DE); JANSEN, Andreas, 46539 Dinslaken (DE); HERGET, Florian, 44807 Bochum (DE); BREIDENBACH, Andreas, 50321 Brühl (DE); PATBERG, Lothar, 47445 Moers (DE)
(74) Vertreter: Cohausz & Florack
(86) Internationale Anmeldenummer: PCT/EP2012/074505
(87) Internationale Veröffentlichungsnummer: WO 2013/092215

(56) Entgegenhaltungen:
- EP-A2- 1 241 926
- WO-A1-2011/074091
- DE-B3-102009 039 600
- US-A- 5 045 637

## Beschreibung

Die Erfindung betrifft eine Magnetfeldabschirmung für elektromagnetische Felder, vorzugsweise im Frequenzbereich von 50 Hz bis 200 kHz, insbesondere von 60 kHz bis 200 kHz, im Wesentlichen bestehend aus einem aus mindestens drei übereinander angeordneten Schichten gebildeten Verbundblech, wobei mindestens eine der Schichten aus Elektroblech oder Elektroband besteht. Ferner betrifft die Erfindung ein Fahrzeug, insbesondere ein elektrisch angetriebenes Kraftfahrzeug, mit einer derartigen Magnetfeldabschirmung.

Aus der EP 1 241 926 A2 ist eine Magnetfeldabschirmung für elektromagnetische Felder im Frequenzbereich von 10 Hz bis 1 kHz bekannt, die aus mindestens zwei Schichten aufgebaut ist. Eine Schicht besteht dabei aus Elektroblech und eine zweite Schicht aus NE-Metall, vorzugsweise Aluminium.

Des Weiteren ist aus der DE 10 2009 039 600 B3 eine Magnetfeldabschirmung für elektromagnetische Felder im Frequenzbereich von 0 Hz bis 50 kHz bekannt, die aus mindestens zwei Schichten aufgebaut ist, wobei mindestens eine Schicht aus einem nicht-kornorientierten Elektroblech und mindestens eine Schicht aus Aluminium besteht, wobei diese Schichten jeweils aus miteinander im Stumpfstoß und/oder überlappend verschweißten Platten aufgebaut sind.

Insbesondere bei Magnetfeldabschirmungen für Fahrzeuge besteht ein Bedarf nach kostengünstigen und möglichst leichtgewichtigen Magnetfeldabschirmungen. Die Verwendung von Aluminium bietet zwar die Möglichkeit, das Gewicht einer Magnetfeldabschirmung der eingangs genannten Art zu reduzieren. Aluminium ist jedoch ein relativ teurer Werkstoff. Zudem erfordert Aluminiumblech für die Herstellung von Schweißverbindungen spezielle Fügewerkzeuge, die relativ teuer und hinsichtlich ihres Einsatzes mitunter problematisch sind.

Der vorliegenden Erfindung liegt die Aufgabe zugrunde, eine Magnetfeldabschirmung der eingangs genannten Art zu schaffen, die eine gute Abschirmwirkung aufweist und zugleich hervorragende Konstruktions- und/oder Funktionseigenschaften vereint.

Zur Lösung dieser Aufgabe wird eine Magnetfeldabschirmung mit den Merkmalen des Anspruchs 1 vorgeschlagen.

Bevorzugte und vorteilhafte Ausgestaltungen der erfindungsgemäßen Magnetfeldabschirmung sind in den Unteransprüchen angegeben.

Die erfindungsgemäße Magnetfeldabschirmung weist (anstelle einer Aluminiumschicht bzw. eines Aluminiumblechs) mindestens eine Schicht aus Stahlblech und zusätzlich mindestens eine Schicht aus Kunststoff und/oder Elastomer auf, wobei die mindestens eine Schicht aus Kunststoff und/oder Elastomer die mindestens eine Schicht aus Elektroblech oder Elektroband und die mindestens eine Schicht aus Stahlblech miteinander stoffschlüssig verbindet.

Stahlbleche sind im Rahmen der vorliegenden Erfindung alle Stahlgüten, die Eigenschaften aufweisen, die nicht mit Elektroblech- oder Elektrobandgüten gleichgesetzt werden.

Die erfindungsgemäße Magnetfeldabschirmung stellt beispielsweise kein zusätzliches Anbauteil des Fahrzeuges dar. Vielmehr übernimmt die erfindungsgemäße Magnetfeldabschirmung insbesondere als Karosserie- oder Fahrwerkbauteil zugleich weitere Funktionen bzw. Aufgaben wie beispielsweise die Abdichtung des Fahrzeuginnenraums gegenüber der Umgebung und/oder die Erfüllung von an die Karosserie gestellte Crash- bzw. Steifigkeitsanforderungen oder Fahrwerksfunktionen. Durch diese Funktionsintegration kann beispielsweise auf eine zusätzliche Schirmwand verzichtet werden; oder eine zusätzliche Schirmwand zur Abschirmung elektromagnetischer Felder kann erheblich kleiner und/oder leichter dimensioniert werden. Hierdurch ergeben sich jeweils eine Gewichtsreduktion und auch eine Kostenreduktion. Des Weiteren zeichnet sich die erfindungsgemäße Lösung durch einen minimierten Bauraumbedarf aus. Die Verwendung mindestens eines Stahlblechs trägt im Wesentlichen zur Erfüllung der an die Konstruktion und/oder Festigkeit gestellten Anforderungen bei.

Besondere Vorteile gegenüber bekannten Lösungen ergeben sich mit der erfindungsgemäßen Magnetfeldabschirmung bei elektromagnetischen Feldern im Frequenzbereich von 50 Hz bis 200 kHz, insbesondere von 60 kHz bis 200 kHz.

Die mindestens eine Schicht aus Kunststoff und/oder Elastomer, welche die Metallbleche der erfindungsgemäßen Magnetfeldabschirmung verbindet, kann zudem eine akustische und/oder wärmeisolierende Funktion übernehmen. Denn durch diese Schicht lässt sich sowohl die Schallisolation (insbesondere Schalldämmung) als auch die Wärmeisolation an dem betreffenden Fahrzeug verbessern. Vorzugsweise ist die Schicht aus Kunststoff und/oder Elastomer dicker als die mindestens eine Schicht aus Elektroblech und/oder die mindestens eine Schicht aus Stahlblech.

Vorzugsweise ist das Verbundblech als Karosserie- oder Fahrwerksbauteil ausgebildet.

Die vorstehend genannten Vorteile der erfindungsgemäßen Magnetfeldabschirmung ergeben sich insbesondere dann, wenn das Karosseriebauteil nach einer bevorzugten Ausgestaltung ein Bodenblech eines elektrisch angetriebenen, mit einer wiederaufladbaren Batterie ausgerüsteten Kraftfahrzeuges definiert.

Eine weitere bevorzugte Ausgestaltung der Erfindung ist dadurch gekennzeichnet, dass die als Bodenblech ausgebildete Magnetfeldabschirmung eine mulden- oder tunnelförmige Struktur aufweist, in der eine Spule zum induktiven Laden der Batterie angeordnet ist. Durch diese geometrische Ausgestaltung der Magnetfeldabschirmung und die Anordnung der Spule in der mulden- oder tunnelförmigen Struktur lässt sich die Abschirmwirkung der Magnetfeldabschirmung ohne zusätzliche Bauteile verbessern.

Nach einer weiteren vorteilhaften Ausgestaltung der Erfindung ist an dem Bodenblech eine aus Klappen, einem Kragen oder Faltenbalg gebildete Abschirmung montiert, die die Spule umgibt und mit einem Antrieb versehen ist, so dass sie aus einer eingeklappten oder angehobenen Position in eine ausgeklappte oder abgesenkte Position und umgekehrt verstellbar ist. Durch diese verstellbare Abschirmung lässt sich ein Bereich unterhalb der Spule sperren, so dass Tiere, beispielsweise eine Katze, keinen Zugang zu dem abgesperrten Bereich unterhalb der Spule hat. Vorzugsweise ist diese verstellbare Abschirmung ebenfalls als Magnetfeldabschirmung ausgebildet.

Eine weitere vorteilhafte Ausgestaltung der Erfindung ist dadurch gekennzeichnet, dass an dem Bodenblech ein Antrieb montiert ist, mittels dem die dem Laden der Batterie dienende Spule aus einer angehobenen Position in eine abgesenkte Position und umgekehrt verfahrbar ist. In der abgesenkten Position wirkt die Spule zugleich als Absperrung für Tiere. Ferner ist der Abstand zwischen Bodenblech und Spule in der abgesenkten Position der Spule vergrößert bzw. der Abstand zwischen der am Fahrzeug angebrachten Spule und einer dieser zugeordneten, in der Fahrbahn integrierten Spule verkleinert, wodurch die Belastung durch elektromagnetische Wechselfelder beim induktiven Laden der Batterie reduziert werden kann.

Nach einer weiteren vorteilhaften Ausgestaltung kann die als Karosseriebauteil ausgeführte Magnetfeldabschirmung insbesondere auch als Längs- oder Querträger ausgebildet sein. Denn häufig können Längs- oder Querträger einer Fahrzeugkarosserie zur Aufnahme von Elektronikbauteilen genutzt werden, so dass die dort montierten Elektronikbauteile dann vor elektromagnetischen Störfeldern abgeschirmt sind oder die elektromagnetischen Störfelder zwischen den Elektronikbauteilen zumindest verringert werden.

Ferner ergeben sich die oben genannten Vorteile der erfindungsgemäßen Magnetfeldabschirmung insbesondere auch bei Ausführungsformen, bei denen das Karosseriebauteil eine Wand und/oder einen Boden eines Gehäuses zur Aufnahme einer wiederaufladbaren Batterie definiert. Im Umfeld der Batterie treten beim Laden der Batterie und der Stromabgabe schwankende elektromagnetische Felder auf, welche angrenzende empfindliche Elektronikbauteile stören können. Durch die erfindungsgemäße Magnetfeldabschirmung können durch elektromagnetische Felder verursachte Funktionsstörungen der angrenzenden Elektronikbauteile verhindert oder zumindest deutlich verringert werden.

Vorzugsweise wird die erfindungsgemäße Magnetfeldabschirmung so angeordnet, dass das mindestens eine Elektroblech der elektromagnetischen Strahlungsquelle zugewandt ist.

Um hohe Crash- und Steifigkeitsanforderungen zu erfüllen, sieht eine weitere vorteilhafte Ausgestaltung der erfindungsgemäßen Magnetfeldabschirmung vor, dass das Elektroblech als Kernschicht zwischen zwei Schichten aus Stahlblech angeordnet ist, wobei das Elektroblech beidseitig durch Schichten aus Kunststoff und/oder Elastomer mit den Schichten aus Stahlblech stoffschlüssig verbunden ist. Durch diese Ausgestaltung können zudem die akustischen Eigenschaften der Magnetfeldabschirmung verbessert werden.

Damit die Magnetfeldabschirmung eine besonders hohe Lebensdauer erreicht, ist nach einer weiteren Ausgestaltung vorgesehen, dass das Stahlblech aus Edelstahl gebildet ist.

Eine hohe Lebensdauer kann nach einer weiteren Ausgestaltung auch dadurch erreicht werden, dass das Verbundblech mindestens einseitig mit einer Korrosionsschutzschicht versehen wird.

Damit die Magnetfeldabschirmung bei möglichst geringem Gewicht hohe Crash- und Steifigkeitsanforderungen erfüllt, ist nach einer weiteren Ausgestaltung vorgesehen, dass das Stahlblech aus austenitischem Stahl oder einem höherfesten Stahl mit einer Zugfestigkeit von mindestens 350 MPa, vorzugsweise mindestens 480 MPa, besonders bevorzugt mindestens 650 MPa gebildet ist.

Zur Verbesserung der Bauteilsteifigkeit bei geringem Bauteilgewicht sieht eine weitere bevorzugte Ausgestaltung der erfindungsgemäßen Magnetfeldabschirmung vor, dass sie als Karosserie- oder Fahrwerkbauteil eine durch Umformen erzeugte dreidimensionale Struktur aufweist. Insbesondere kann die erfindungsgemäße Magnetfeldabschirmung als Karosseriebauteil eine mulden- oder tunnelförmige Struktur aufweisen.

Nachfolgend wird die Erfindung anhand einer mehrere Ausführungsbeispiele darstellenden Zeichnung näher erläutert. Es zeigen schematisch:
- Fig. 1: einen Abschnitt einer dreischichtigen Magnetfeldabschirmung, in Schnittansicht;
- Fig. 2: einen Abschnitt einer fünfschichtigen Magnetfeldabschirmung, in Schnittansicht;
- Fig. 3: einen Abschnitt eines Bodenblechs eines Elektrofahrzeugs, in Schnittansicht;
- Fig. 4: einen Abschnitt eines Bodenblechs eines Elektrofahrzeugs gemäß einem weiteren Ausführungsbeispiel, in Schnittansicht;
- Fig. 5: einen Abschnitt eines Bodenblechs eines Elektrofahrzeugs gemäß einem weiteren Ausführungsbeispiel, in Schnittansicht; und
- Fig. 6: einen Abschnitt eines Bodenaufbaus eines Elektrofahrzeugs mit einem Batteriegehäuse, in Schnittansicht;

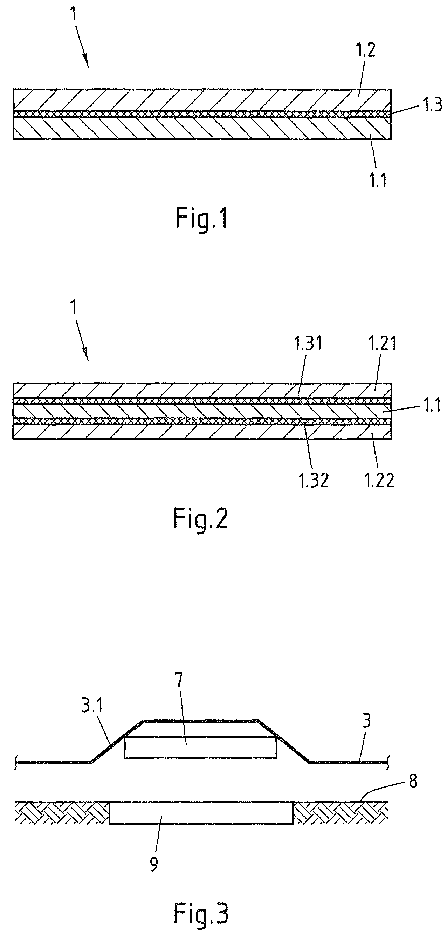

In Fig. 1 ist ein Abschnitt eines dreischichtigen Verbundblechs (Sandwichblechs) 1 dargestellt, das als Magnetfeldabschirmung für elektromagnetische Felder, insbesondere im Frequenzbereich von 50 Hz bis 200 kHz, geeignet ist und durch Zuschneiden und/oder Umformen zu einem Karosserie- oder Fahrwerkbauteil eines Fahrzeugs, insbesondere Elektrofahrzeugs weiterverarbeitet wird.

Mit dem Bezugszeichen 1.1 ist eine Schicht aus Elektroblech bezeichnet. Dabei kann es sich um ein kornorientiertes oder ein nicht-kornorientiertes Elektroblech handeln. Die Abschirmung elektromagnetischer Felder wird hauptsächlich durch die Schicht 1.1 bzw. das Elektroblech geleistet.

Ferner umfasst das Sandwichblech 1 gemäß Fig. 1 eine Schicht 1.2 aus Stahlblech und eine Schicht 1.3 aus Kunststoff und/oder Elastomer. Die an das Karosserie- oder Fahrwerkbauteil gestellten konstruktiven Anforderungen werden im Wesentlichen bzw. größtenteils durch die Schicht 1.2 aus Stahlblech erfüllt. Die Schicht 1.3 aus Kunststoff und/oder Elastomer dient der Verbindung der metallischen Schichten 1.1, 1.2. Sie kann auch als Klebeschicht bezeichnet werden. Darüber hinaus kann die Schicht 1.3 die akustischen Eigenschaften der als Karosserie- oder Fahrwerkbauteil ausgeführten Magnetfeldabschirmung verbessern. Das erfindungsgemäße Sandwichblech 1 erfüllt somit alle Anforderungen (Abschirmung, Konstruktion). Hier nicht dargestellt, kann die Schicht 1.3 dicker als mindestens eine der metallischen Schichten 1.1, 1.2 sein.

In Fig. 2 ist ein zweites Ausführungsbeispiel eines erfindungsgemäßen Verbundblechs (Sandwichblechs) 1 zur Herstellung eines Karosserie- oder Fahrwerkbauteils mit integrierter Magnetfeldabschirmung dargestellt. Das Sandwichblech 1 weist eine Kernschicht 1.1 aus Elektroblech auf. Die Kernschicht 1.1 ist beidseitig durch Schichten 1.31, 1.32 aus Kunststoff und/oder Elastomer mit Schichten 1.21, 1.22 aus Stahlblech stoffschlüssig verbunden. Die Verbindungsschichten (Klebeschichten) 1.31, 1.32 können die akustischen Eigenschaften des Sandwichblechs 1 verbessern. Sie können auch (hier nicht dargestellt) dicker als mindestens eine der metallischen Schichten 1.21, 1.22 sein.

Bei dem in den Sandwichblechen 1 gemäß den Figuren 1 und 2 verwendeten Stahlblech 1.2 bzw. 1.21, 1.22 handelt es sich beispielsweise um Blech aus austenitischem Stahl, Edelstahl und/oder höherfestem Stahl, insbesondere Dualphasen-Stahl. Die Zugfestigkeit des für die Schicht(en) 1.2 bzw. 1.21, 1.22 verwendeten Stahlblechs beträgt mindestens 350 MPa, vorzugsweise mindestens 480 MPa, besonders bevorzugt mindestens 650 MPa.

In den Figuren 3 bis 5 sind mehrere Ausführungsbeispiele eines Bodens 3 eines Elektrofahrzeugs skizziert. In dem Boden 3 ist jeweils eine tunnel- oder muldenförmige Einwölbung 3.1 eingeformt. In der Einwölbung 3.1 ist eine Spule 7 zum induktiven Laden der Batterie des Elektrofahrzeugs angeordnet. Mit 8 ist eine Fahrbahn oder Abstellfläche bezeichnet, in der mindestens eine Spule 9 zum induktiven Laden von Elektrofahrzeugen integriert ist. Die Abstellfläche 8 mit der integrierten Ladespule 9 kann sich beispielsweise in einer Garage oder einem Parkhaus befinden.

Das Bodenblech 3 ist in den in den Figuren 3 bis 5 skizzierten Ausführungsbeispielen jeweils aus einem Sandwichblech 1 gemäß Fig. 1 oder Fig. 2 hergestellt. Bei Verwendung eines Sandwichblechs 1 gemäß Fig. 1 ist das Elektroblech 1.2 vorzugsweise der Spule 7 zugewandt. Eine Verwendung des Elektroblechs auf der der Spule 7 abgewandten Seite liegt ebenfalls im Rahmen der Erfindung. Ferner ist das Sandwichblech 1 gemäß Fig. 1 vorzugsweise zumindest auf seiner der Spule 7 zugewandten Seite mit einer Korrosionsschutzschicht, beispielsweise einer Zink- oder Zink-Nickelschicht versehen.

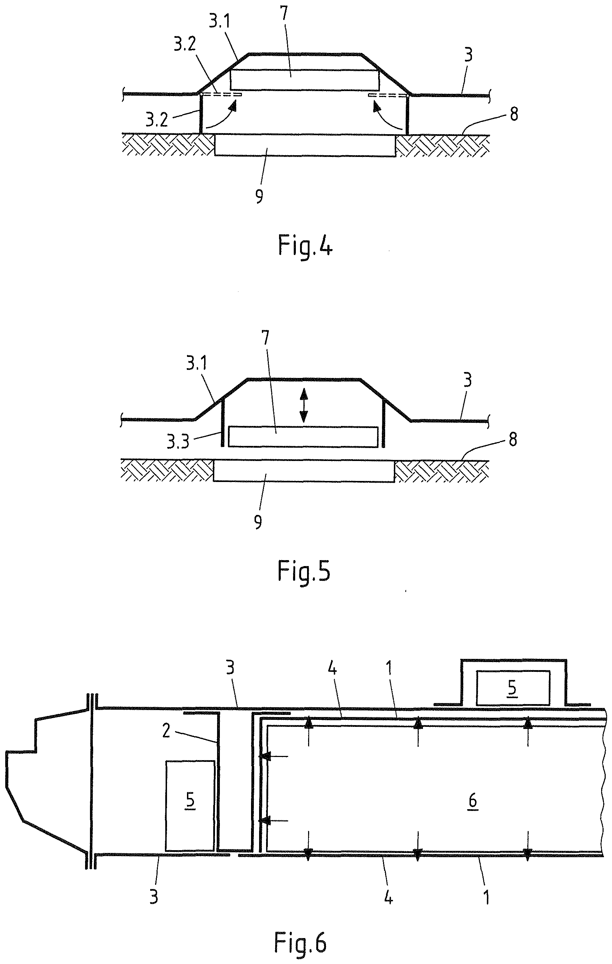

Bei dem Ausführungsbeispiel gemäß Fig. 4 ist an dem Bodenblech 3 eine aus Klappen 3.2 gebildete Abschirmung montiert, die die Spule 7 umgibt und mit einem Antrieb (nicht gezeigt) versehen ist, so dass sie aus einer eingeklappten oder hochgelegenen Position in eine ausgeklappte oder abgesenkte Position und umgekehrt verstellt werden kann. Während der Fahrt des Elektrofahrzeugs sind die Klappen 3.2 nach oben geklappt. Während des induktiven Ladens der Batterie des Elektrofahrzeugs auf der Abstellfläche 8 befinden sich die Klappen 3.2 dagegen in der nach unten geklappten Stellung. Beide Positionen (Stellungen) der Klappen 3.2 sind in Fig. 4 eingezeichnet.

Bei dem Ausführungsbeispiel gemäß Fig. 5 ist an dem Bodenblech 3 ein Antrieb (nicht gezeigt) montiert, mittels dem die Spule 7 aus einer angehobenen Position in eine abgesenkte Position und umgekehrt verfahrbar ist. Die Bezugszeichen 3.3 sind einer Führung der absenk- und anhebbaren Spule 7 bzw. einer von der Spule 7 zu der Batterie 6 führenden Stromleitung zugeordnet (vgl. Fig. 6).

In Fig. 6 ist ein Bodenaufbau eines Elektrofahrzeugs dargestellt. Der Boden des Elektrofahrzeugs ist aus Längs- und Querträgern 2 und mindestens einem Bodenblech 3 aufgebaut. In dem Boden ist ein Batteriegehäuse (Batteriekammer) 4 aufgenommen bzw. integriert. In dem Boden und/oder auf demselben sind Elektronikbauteile 5 montiert. Je nach Leistungsaufnahme bzw. Leistungsabgabe der Batterie 6 treten schwankende elektromagnetische Felder auf, die die Elektronikbauteile stören können. Die Störfelder sind durch kleine am Batteriegehäuse 4 angeordnete Pfeile schematisch angedeutet. Durch gut abschirmende Materialien in den Strukturbauteilen des Bodenaufbaus bzw. des Batteriegehäuses 4 werden elektromagnetische Störfelder zwischen den Elektronikbauteilen 5 verringert. Hierzu sind das Bodenblech 3, die Quer- und/oder Längsträger 2 und/oder das Batteriegehäuse 4 aus Sandwichblech 1 gemäß Fig. 1 und/oder Fig. 2 hergestellt. Die Schicht 1.2 (bzw. 1.21 und/oder 1.22) des Sandwichblechs 1 besteht dabei vorzugsweise aus hochfestem Stahl mit einer Zugfestigkeit von mindestens 480 MPa, besonders bevorzugt mindestens 650 MPa. Hierdurch lässt sich neben einer guten Abschirmwirkung auch ein hoher Crash-Schutz insbesondere für die Batterie 6 erzielen.

Die Ausführung der vorliegenden Erfindung ist nicht auf die in der Zeichnung dargestellten Ausführungsbeispiele beschränkt. Vielmehr sind zahlreiche Varianten denkbar, die auch bei abweichender Gestaltung von der in den beiliegenden Ansprüchen angegebenen Erfindung Gebrauch machen. Insbesondere kann die erfindungsgemäße Magnetfeldabschirmung auch zwei oder mehr Schichten 1.1 aus Elektroblech aufweisen. Ferner liegt es in Rahmen der vorliegenden Erfindung, die konstruktiven Merkmale der in den Figuren 3 bis 6 skizzierten Ausführungsbeispiele teilweise oder vollständig miteinander zu kombinieren.

## Patentansprüche

1. Magnetfeldabschirmung für elektromagnetische Felder, vorzugsweise im Frequenzbereich von 50 Hz bis 200 kHz, im Wesentlichen bestehend aus einem aus mindestens drei übereinander angeordneten Schichten (1.1, 1.2, 1.3; 1.1, 1.21, 1.22, 1.31, 1.32) gebildeten Verbundblech (1), wobei mindestens eine der Schichten aus Elektroblech oder Elektroband besteht, **dadurch gekennzeichnet, dass** mindestens eine der Schichten aus Stahlblech und mindestens eine der Schichten aus Kunststoff und/oder Elastomer besteht, wobei die mindestens eine Schicht (1.3; 1.31, 1.32) aus Kunststoff und/oder Elastomer die mindestens eine Schicht (1.1) aus Elektroblech oder Elektroband und die mindestens eine Schicht (1.2; 1.21, 1.22) aus Stahlblech miteinander stoffschlüssig verbindet.

2. Magnetfeldabschirmung nach Anspruch 1, **dadurch gekennzeichnet, dass** das Verbundblech (1) als Karosserie-oder Fahrwerkbauteil eines Fahrzeugs ausgeführt ist.

3. Magnetfeldabschirmung nach Anspruch 1 oder 2, **dadurch gekennzeichnet, dass** das Karosseriebauteil ein Bodenblech (3) eines elektrisch angetriebenen, mit einer wiederaufladbaren Batterie (6) ausgerüsteten Kraftfahrzeugs definiert.

4. Magnetfeldabschirmung nach Anspruch 3, **dadurch gekennzeichnet, dass** das Bodenblech (3) eine mulden- oder tunnelförmige Struktur (3.1) aufweist, in der eine Spule (7) zum induktiven Laden der Batterie (6) angeordnet ist.

5. Magnetfeldabschirmung nach Anspruch 4, **dadurch gekennzeichnet, dass** an dem Bodenblech (3) eine aus Klappen (3.2), einem Kragen oder Faltenbalg gebildete Abschirmung montiert ist, die die Spule (7) umgibt und mit einem Antrieb versehen ist, so dass sie aus einer eingeklappten oder angehobenen Position in eine ausgeklappte oder abgesenkte Position und umgekehrt verstellbar ist.

6. Magnetfeldabschirmung nach Anspruch 4 oder 5, **dadurch gekennzeichnet, dass** an dem Bodenblech (3) ein Antrieb montiert ist, mittels dem die Spule (7) aus einer angehobenen Position in eine abgesenkte Position und umgekehrt verfahrbar ist.

7. Magnetfeldabschirmung nach Anspruch 2, **dadurch gekennzeichnet, dass** das Karosseriebauteil als Längs-oder Querträger (2) ausgebildet ist.

8. Magnetfeldabschirmung nach Anspruch 2 oder 3, **dadurch gekennzeichnet, dass** das Karosseriebauteil eine Wand und/oder einen Boden eines Gehäuses (4) zur Aufnahme einer wiederaufladbaren Batterie (6) definiert.

9. Magnetfeldabschirmung nach einem der Ansprüche 1 bis 8, **dadurch gekennzeichnet, dass** das Elektroblech (1.1) einer elektromagnetischen Strahlungsquelle zugewandt ist.

10. Magnetfeldabschirmung nach einem der Ansprüche 1 bis 9, **dadurch gekennzeichnet, dass** das Elektroblech als Kernschicht (1.1) zwischen zwei Schichten (1.21, 1.22) aus Stahlblech angeordnet ist, wobei das Elektroblech (1.1) beidseitig durch Schichten (1.31, 1.32) aus Kunststoff und/oder Elastomer mit den Schichten (1.21, 1.22) aus Stahlblech stoffschlüssig verbunden ist.

11. Magnetfeldabschirmung nach einem der Ansprüche 1 bis 10, **dadurch gekennzeichnet, dass** das Stahlblech (1.2; 1.21, 1.22) aus Edelstahl gebildet ist.

12. Magnetfeldabschirmung nach einem der Ansprüche 1 bis 11, **dadurch gekennzeichnet, dass** das Stahlblech (1.2; 1.21, 1.22) aus austenitischem Stahl oder einem höherfesten Stahl mit einer Zugfestigkeit von mindestens 350 MPa, vorzugsweise mindestens 480 MPa, besonders bevorzugt mindestens 650 MPa gebildet ist.

13. Magnetfeldabschirmung nach einem der Ansprüche 1 bis 12, **dadurch gekennzeichnet, dass** das Verbundblech (1) als Karosserie- oder Fahrwerkbauteil eine durch Umformen hergestellte dreidimensionale Struktur aufweist.

14. Magnetfeldabschirmung nach einem der Ansprüche 1 bis 13, **dadurch gekennzeichnet, dass** das Verbundblech (1) als Karosseriebauteil eine mulden- oder tunnelförmige Struktur (3.1) aufweist.

15. Magnetfeldabschirmung nach einem der Ansprüche 1 bis 14, **dadurch gekennzeichnet, dass** das Verbundblech (1) mindestens einseitig mit einer Korrosionsschutzschicht versehen ist.

16. Fahrzeug, insbesondere elektrisch angetriebenes Kraftfahrzeug, mit einer integrierten Magnetfeldabschirmung nach einem der Ansprüche 1 bis 15.

## Claims

1. Magnetic field shield for electromagnetic fields, preferably in the frequency range of from 50 Hz to 200 kHz, substantially consisting of a composite metal sheet (1) formed of at least three superimposed layers (1.1, 1.2, 1.3; 1.1, 1.21, 1.22, 1.31, 1.32), at least one of the layers consisting of an electrical metal sheet or an electrical strip, **characterised in that** at least one of the layers consists of a steel sheet and at least one of the layers consists of a plastics material and/or an elastomer, the at least one layer (1.3; 1.31, 1.32) consisting of a plastics material and/or an elastomer integrally bonding the at least one layer (1.1) consisting of an electrical metal sheet or an electrical strip to the at least one layer (1.2; 1.21, 1.22) consisting of a steel sheet.

2. Magnetic field shield according to claim 1, **characterised in that** the composite metal sheet (1) is designed as a bodywork or chassis component of a vehicle.

3. Magnetic field shield according to either claim 1 or claim 2, **characterised in that** the bodywork component defines a floor panel (3) of an electrically driven motor vehicle that is equipped with a rechargeable battery (6).

4. Magnetic field shield according to claim 3, **characterised in that** the floor panel (3) has a trough-shaped or tunnel-shaped structure (3.1), in which a coil (7) for inductively charging the battery (6) is arranged.

5. Magnetic field shield according to claim 4, **characterised in that** a shield formed of flaps (3.2), a collar or a bellow is mounted on the floor panel (3), surrounds the coil (7) and is provided with a drive, such that said shield can be moved out of a retracted or raised position into a deployed or lowered position, and vice versa.

6. Magnetic field shield according to either claim 4 or claim 5, **characterised in that** a drive is mounted on the floor panel (3), by means of which drive the coil (7) can be moved out of a raised position into a lowered position, and vice versa.

7. Magnetic field shield according to claim 2, **characterised in that** the bodywork component is designed as a side or cross member (2).

8. Magnetic field shield according to either claim 2 or claim 3, **characterised in that** the bodywork component defines a wall and/or a floor of a housing (4) for receiving a rechargeable battery (6).

9. Magnetic field shield according to any of claims 1 to 8, **characterised in that** the electrical metal sheet (1.1) is facing an electromagnetic radiation source.

10. Magnetic field shield according to any of claims 1 to 9, **characterised in that** the electrical metal sheet is arranged as a core layer (1.1) between two layers (1.21, 1.22) consisting of a steel sheet, the electrical metal sheet (1.1) being integrally bonded on both sides to the layers (1.21, 1.22) consisting of a steel sheet by means of layers (1.31, 1.32) consisting of a plastics material and/or an elastomer.

11. Magnetic field shield according to any of claims 1 to 10, **characterised in that** the steel sheet (1.2; 1.21, 1.22) is made of stainless steel.

12. Magnetic field shield according to any of claims 1 to 11, **characterised in that** the steel sheet (1.2; 1.21, 1.22) is made of austenitic steel or a higher-strength steel having a tensile strength of at least 350 MPa, preferably at least 480 MPa, particularly preferably at least 650 MPa.

13. Magnetic field shield according to any of claims 1 to 12, **characterised in that** the composite metal sheet (1) has a three-dimensional structure produced by means of forming as a bodywork or chassis component.

14. Magnetic field shield according to any of claims 1 to 13, **characterised in that** the composite metal sheet (1) has a trough-shaped or tunnel-shaped structure (3.1) as a bodywork component.

15. Magnetic field shield according to any of claims 1 to 14, **characterised in that** the composite metal sheet (1) is provided on at least one side with a corrosion protection layer.

16. Vehicle, in particular an electrically driven motor vehicle, comprising an integrated magnetic field shield according to any of claims 1 to 15.

## Revendications

1. Blindage de champ magnétique pour champs électromagnétiques, de préférence dans le domaine de fréquences de 50 Hz à 200 kHz, qui consiste essentiellement en une tôle composite (1) consistant en au moins trois couches superposées (1.1, 1.2, 1.3 ; 1.1., 1.21, 1.22, 1.31, 1.32), sachant qu'au moins l'une des couches consiste en tôle électrique ou en ruban électrique, **caractérisé en ce que** l'une des couches au moins est en tôle d'acier et qu'au moins l'une des couches est en matière synthétique et / ou en élastomère, sachant que l'au moins une couche (1.3 ; 1.31, 1.32) en matière synthétique et / ou en élastomère, relie ensemble, par liaison de matière, l'au moins une couche (1.1) en tôle électrique ou en ruban électrique et l'au moins une couche en tôle d'acier (1.2 ; 1.21, 1.22).

2. Blindage de champ magnétique selon la revendication 1, **caractérisé en ce que** la tôle composite (1) est réalisée sous la forme d'un composant de carrosserie ou d'un composant de châssis d'un véhicule automobile.

3. Blindage de champ magnétique selon revendication 1 ou 2, **caractérisé en ce que** le composant de carrosserie définit une tôle de plancher (3) d'un véhicule automobile à entraînement électrique, qui est équipé d'une batterie rechargeable (6).

4. Blindage de champ magnétique selon la revendication 3, **caractérisé en ce que** la tôle de plancher (3) est dotée d'une structure en forme de cavité ou de tunnel (3.1), dans laquelle est disposée une bobine (7) pour la charge inductive de la batterie (6).

5. Blindage de champ magnétique selon la revendication 4, **caractérisé en ce que**, sur la tôle de plancher (3), est monté un blindage, qui, composé de volets (3.2) ou d'un col ou d'un soufflet, entoure la bobine (7) et est doté d'un entraînement, de manière à ce qu'il puisse être conduit d'une position pliée ou soulevée à une position dépliée ou abaissée et inversement.

6. Blindage de champ magnétique selon revendication 4 ou 5, **caractérisé en ce que**, sur la tôle de plancher (3) est monté un entraînement, au moyen duquel la bobine (7) peut être conduite d'une position soulevée à une position abaissée et inversement.

7. Blindage de champ magnétique selon la revendication 2, **caractérisé en ce que** le composant de carrosserie est réalisé sous la forme d'un support longitudinal ou d'un support transversal (2).

8. Blindage de champ magnétique selon revendication 2 ou 3, **caractérisé en ce que** le composant de carrosserie définit une paroi et / ou un fond d'un réceptacle (4) pour une batterie (6) rechargeable.

9. Blindage de champ magnétique selon l'une des revendications 1 à 8, **caractérisé en ce que** la tôle électrique (1.1) est orientée vers une source de rayonnement électromagnétique.

10. Blindage de champ magnétique selon l'une des revendications 1 à 9, **caractérisé en ce que** la tôle électrique est disposée en tant que couche de coeur (1.1), entre deux couches en tôle d'acier (1.21, 1.22), sachant que la tôle électrique (1.1) est reliée, des deux côtés, par liaison de matière, aux couches en tôle d'acier (1.21, 1.22), par des couches 1.31, 1.32) en matière synthétique et / ou en élastomère.

11. Blindage de champ magnétique selon l'une des revendications 1 à 10, **caractérisé en ce que** la tôle d'acier (1.2 ; 1.21, 1.22) est réalisée en acier inoxydable.

12. Blindage de champ magnétique selon l'une des revendications 1 à 11, **caractérisé en ce que** la tôle d'acier (1.2 ; 1.21, 1.22) est réalisée en acier austénitique ou en acier de résistance plus élevée, doté d'une résistance à la traction d'au moins 350 MPa, de préférence d'au moins 480 MPa, en particulier d'au moins 650 MPa.

13. Blindage de champ magnétique selon l'une des revendications 1 à 12, **caractérisé en ce que** la tôle composite (1) est dotée, en tant que composant de carrosserie ou de châssis, d'une structure (3.1) tridimensionnelle, réalisée par formage.

14. Blindage de champ magnétique selon l'une des revendications 1 à 13, **caractérisé en ce que** la tôle composite (1) est dotée, en tant que composant de carrosserie, d'une structure (3.1) en forme de cavité ou de tunnel.

15. Blindage de champ magnétique selon l'une des revendications 1 à 14, **caractérisé en ce que** la tôle composite (1) est dotée, au moins d'un côté, d'une couche de protection contre la corrosion.

16. Véhicule automobile, en particulier véhicule automobile entraîné électriquement, dans lequel est intégré un blindage de champ magnétique selon l'une des revendications 1 à 15.
